# EUROPEAN PATENT SPECIFICATION

(11) **EP 3 373 108 B1**
(45) Date of publication and mention of the grant of the patent: **19.04.2023**
(21) Application number: 18159112.4
(22) Date of filing: 28.02.2018
(51) Int. Cl.: G06F 1/18, H05K 5/00, H05K 7/14, H02B 1/044

(54) **BRACKET FOR FIXING ELECTRONIC DEVICE AND MECHANISM FOR FIXING ELECTRONIC DEVICE**
HALTERUNG ZUR BEFESTIGUNG EINER ELEKTRONISCHEN VORRICHTUNG UND MECHANISMUS ZUR BEFESTIGUNG EINER ELEKTRONISCHEN VORRICHTUNG
SUPPORT POUR FIXER UN DISPOSITIF ÉLECTRONIQUE ET MÉCANISME DE FIXATION DE DISPOSITIF ÉLECTRONIQUE

(30) Priority: 06.03.2017 KR 20170028245
(43) Date of publication of application: 12.09.2018
(73) Proprietor: LSIS Co., Ltd., Gyeonggi-do 14119 (KR)
(72) Inventor: JOO, Sang-Oh, 14118 Gyeonggi-do (KR)
(74) Representative: K&L Gates LLP

(56) References cited:
- DE-U1-212013 000 290
- JP-U- S56 117 584
- US-A- 3 829 599
- US-A1- 2003 209 645
- US-B1- 9 494 984

## Description

### BACKGROUND

### 1. Technical Field

The present disclosure relates to a bracket for fixing an electronic device, and more particularly, to a bracket capable of fixing an electronic device to an enclosure by forming a stable fixing force, and mechanism for fixing an electronic device.

### 2. Description of the Related Art

Typically, an electronic device such as an HMI device and a panel PC has a structure fixed to an enclosure.

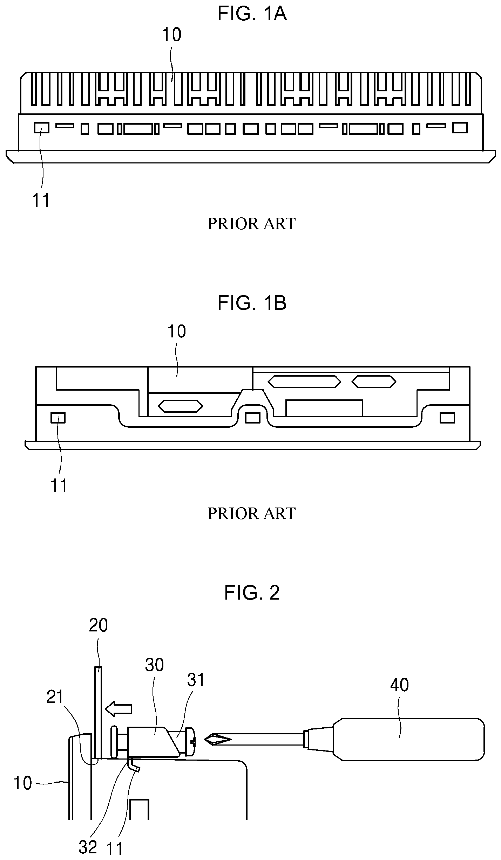

FIGS. 1A and 1B are views showing upper and lower ends of an existing electronic device, respectively, where slots are formed. FIG. 2 is a view showing the existing electronic device mounted on the enclosure.

Referring to FIGS. 1A and 1B, slots 11 are formed at the corners of each of the upper and lower ends of the electronic device 10.

As shown in FIG. 2, brackets 30 are disposed at the upper and lower ends of the electronic device 10.

In each of the brackets 30, a hook 32 is formed.

The hook 32 is inserted into one of the slots 11 formed at the corners of the upper and lower ends of the electronic device 10 and serves to fix the bracket 30 at that position.

Therefore, each of the brackets 30 are disposed along the periphery of the rear part of the electronic device 10 as shown in FIG. 2.

In addition, the electronic device 10 is located in an opening 21 formed in the enclosure 20 such that its front part protrudes from the front face of the enclosure 20 and its rear part protrudes from the rear face of the enclosure 20.

A screw bolt 31 is screwed into the bracket 30. Both ends of the screw bolt 31 are exposed from both ends of the bracket 30, respectively.

When the screw bolt 31 is rotated in the fastening direction by using a driver 40, the other end of the screw bolt 31 is advanced toward the rear face of the enclosure 20.

Accordingly, the other end of the screw bolt 31 gradually advances so that it may be brought into tight contact with the rear face of the enclosure 20. As a result, the both parts of the electronic device 10 can be fixed together with the enclosure 20 therebetween.

Previously, the bracket 30 is formed by plating, and thus it may be bent when a torque greater than a certain level is applied. Therefore, there is a problem that the bracket cannot fix electronic devices.

In addition, when the screw bolt 31 is screwed into the bracket 30, the other end of the screw bolt 31 comes in direct contact with the rear face of the enclosure 20. Therefore, scratches may be generated on the outer surface of the enclosure 20, or stress may be concentrated on the small contact area.

In the related art, Korean Utility Model Publication No. 20-1994-0014102 discloses a combinating device for front cabinet of electronic device. DE 21 2013 000290 U1, US 9 494 984 B1, US 3 829 599 A, JP S56 117584 U and US 2003/209645 A1 disclose related art.

### SUMMARY

It is an object of the present invention to provide a bracket capable of fixing an electronic device to an enclosure by forming a stable fixing force, and mechanism for fixing an electronic device.

According to an exemplary embodiment of the present invention, there is provided a bracket for fixing an electronic device. An electronic device having the bracket is defined in claim 1.

The bracket fixes an electronic device that is accommodated in an opening formed in an enclosure and has a front cover in tight contact with the front face of the enclosure in the vicinity of the opening.

The bracket includes a bracket body that has a first end supporting a rear part of the electronic device and a second end in contact with a periphery of the rear part of the electronic device; and a coupling member disposed in the bracket body to press the front cover and the second end of the bracket body towards each other from the front and rear faces of the enclosure, to fix the electronic device.

The bracket body has a first portion having a fastening hole through which the coupling member passes, and a second portion bent from an end of the first portion to partially surround the periphery of the rear part of the electronic device.

The coupling member is coupled with the periphery of the rear part of the electronic device by being screwed, and an end of the second portion forms a supporting region in tight contact with the rear face of the enclosure near the opening. The bracket body is formed in an L shape, and a connection portion between the first portion and the second portion is formed to be tapered.

A guide hole may be formed in the periphery of the rear part of the electronic device.

A guide rod may protrude from the first portion, such that it is inserted into the guide hole to guide movement.

The guide hole may be formed in a shape conforming to the guide rod.

The longitudinal section of the guide rod may be formed in a polygonal shape.

A guide groove for guiding the movement of the second portion may be further formed on the periphery of the rear part of the electronic device.

An elastic member may be interposed between the front cover and the enclosure.

According to another exemplary embodiment of the present invention, there is provided a mechanism for fixing an electronic device according to claim 6.

According to exemplary embodiments of the present invention, an electronic device can be fixed to an enclosure by forming stable fixing force.

### BRIEF DESCRIPTION OF DRAWINGS

FIGS. 1A and 1B are views showing upper and lower ends of an existing electronic device, respectively, where slots are formed;
FIG. 2 is a view showing the existing electronic device mounted on the enclosure;
FIG. 3 is a perspective view showing a front face of an electronic device installed in an enclosure by brackets for fixing an electronic device according to an exemplary embodiment of the present invention;
FIG. 4 is a perspective view showing a rear face of an electronic device installed in an enclosure by brackets for fixing an electronic device according to an exemplary embodiment of the present invention;
FIG. 5 is a perspective view showing a configuration of a bracket for fixing an electronic device according to an exemplary embodiment of the present invention;
FIG. 6 is a perspective view showing the rear part 101 of the electronic device where the brackets are disposed;
FIG. 7 is a view showing the electronic device fixed to the enclosure by using the bracket according to the exemplary embodiment of the present invention;
FIG. 8 is a view showing the elastic member interposed between the front cover and the enclosure according to the exemplary embodiment of the present invention;
FIG. 9 is a cross-sectional view showing the bracket when it is installed;
FIG. 10 is a view showing another example of the guide member; and
FIG. 11 is a view showing an example of a guide groove formed in an outer side surface of the periphery of the rear part of the electronic device.

### DETAILED DESCRIPTION

In the following detailed description, reference is made to the accompanying drawings that show, by way of illustration, specific embodiments in which the claimed subject matter may be practiced. These embodiments are described in sufficient detail to enable those skilled in the art to practice the subject matter.

The present invention may, however, be embodied in many different forms and should not be construed as limited to the embodiments set forth herein.

Elements well known in the art have been omitted in order not to unnecessarily obscure the gist of the present invention.

Like reference numerals designate like elements throughout the specification.

As used herein, when an element such as a layer, region, substrate, or panel is referred to as being "on" or "under" another element, it can be directly on or under the other element.

In addition, it does not exclude that an intervening elements may also be present between the two elements.

Hereinafter, a bracket for fixing an electronic device and mechanism for fixing an electronic device will be described with reference to the accompanying drawings.

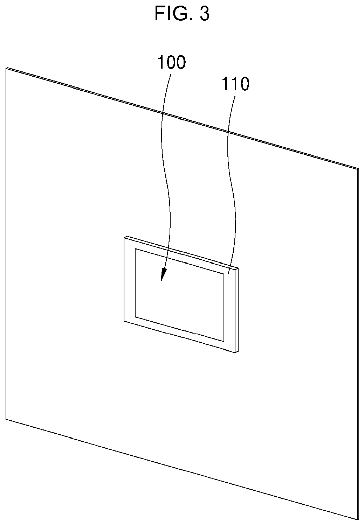

FIG. 3 is a perspective view showing a front face of an electronic device installed in an enclosure by brackets for fixing an electronic device according to an exemplary embodiment of the present invention.

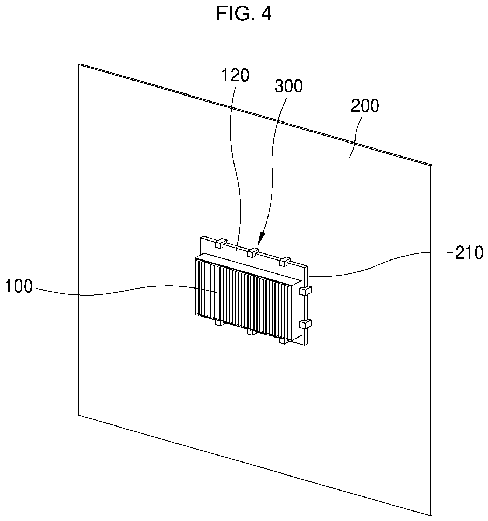

FIG. 4 is a perspective view showing a rear face of an electronic device installed in an enclosure by brackets for fixing an electronic device according to an exemplary embodiment of the present invention.

Referring to FIGS. 3 and 4, a bracket 300 for fixing an electronic device according to an exemplary embodiment fixes an electronic device 100 that is disposed in an opening 210 formed in an enclosure 200 and has a front cover 110 formed along the periphery in contact with the vicinity of the opening 210 at the front face of the enclosure 200.

The electronic device 100 may include an HMI device, a panel PC, etc.

The front cover 110 is formed along the periphery of the front part of the electronic device 100 and is expanded outwardly.

The electronic device 100 is fitted into the opening 210 formed in the enclosure 200.

The front cover 110 is exposed from the front face of the enclosure 200 and is in contact with the vicinity of the opening 210.

Although not shown in the drawings, an elastic layer (not shown) may be further formed on an inner side surface of the front cover 210 so that the front cover 210 can be in tight contact with the enclosure 200 with elasticity.

The rear part of the electronic device 100 is disposed to protrude from the rear face of the enclosure 200 through the opening 210 as shown in FIG. 4.

A plurality of brackets 300 according to the exemplary embodiment of the present invention is disposed such that the periphery of the rear part of the electronic device 100 is in tight contact with the vicinity of the opening 210 at the rear face of the enclosure 200.

In addition, in the rear face of the enclosure 200, a supporting region is formed, which is brought into tight contact with the end of the second portion 312 and pressed.

According to the exemplary embodiment of the present invention, the electronic device 100 may be installed in tight contact with the enclosure 200 by pressing the front cover 110 disposed at the front face of the enclosure 200 and the brackets 130 disposed at the rear face of the enclosure 200 towards each other when the electronic device 100 is located in the opening 210.

Subsequently, the configuration of the brackets 300 having the above-described functions will be described.

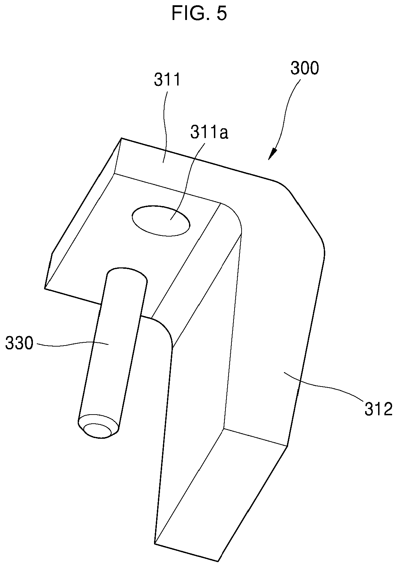

FIG. 5 is a perspective view showing a configuration of a bracket for fixing an electronic device according to an exemplary embodiment of the present invention.

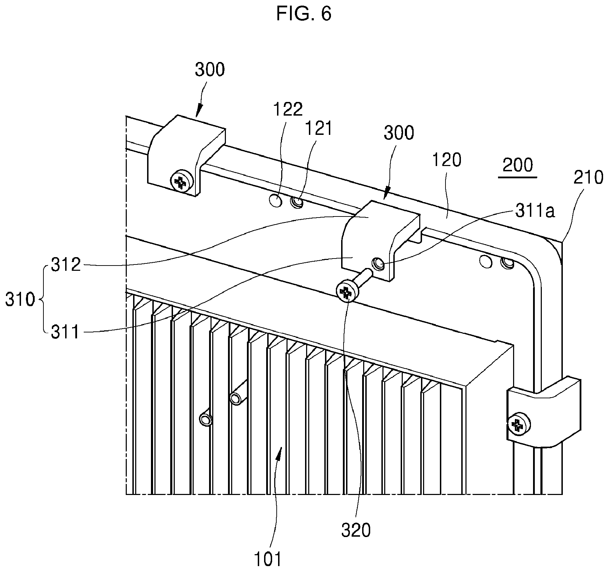

FIG. 6 is a perspective view showing the rear part 101 of the electronic device where the brackets are disposed.

Referring to FIG. 5, the bracket 300 according to the exemplary embodiment of the present disclosure may include a bracket body 310 having a first portion 311 and a second portion 312, and a coupling member 320.

The first portion 311 is disposed in tight contact with the rear part 101 of the electronic device 100.

The second portion 312 is bent from the end of the first portion 311 and disposed to be in tight contact with the side surface of the periphery 120 of the rear part of the electronic device 100.

Preferably, the angle between the first and second portions 311 and 312 may be equal to the angle between the rear face and the top face of the periphery 120 of the rear part of the electronic device 100.

In addition, an end of the second portion 312 is in contact with the rear face of the enclosure 200.

A through hole 311a is formed in the first portion 311, via which the coupling member 320 passes.

Preferably, the coupling member 320 is a screw bolt.

Fastening holes 121 are formed along the periphery of the rear part of the electronic device 100 such that they are spaced apart from one another.

The fastening hole 121 is aligned with the through-hole 311a, so that the coupling member 320 may be inserted through the through hole 311a and the fastening hole 121.

By doing so, the first portion 311 can be fixed to the periphery 120 of the rear part of the electronic device 100.

The first and second portions 311 and 312 may move forward and backward depending on the degree at which the coupling member 320 is fastened.

Specifically, when the coupling member 320 is rotated in the direction that it is fastened as being inserted into the through hole 311a, the second portion 312 moves toward the rear face of the enclosure 200.

On the contrary, when the coupling member 320 is rotated in the opposite direction that it is released as being inserted into the through hole 311a, the second portion 312 moves away from the rear face of the enclosure 200.

A guide rod 330 is formed at the first portion 311, which has a predetermined length and protrudes from it.

Preferably, a guide hole 122 may be formed in the periphery 120 of the rear part of the electronic device 100.

The shape of the guide rod 330 may be a circular bar, and the shape of the guide hole 122 may be a cylindrical hole.

Accordingly, the first portion 311 moves back and forth as the guide rod 330 is inserted into the guide hole 122, and thus the movement is guided so that it is possible to prevent the first portion 311 from deviating.

Preferably, the guide hole 122 has the shape conforming to the cross section of the guide rod 330.

Next, a mechanism for fixing an electronic device employing the above-described brackets will be described.

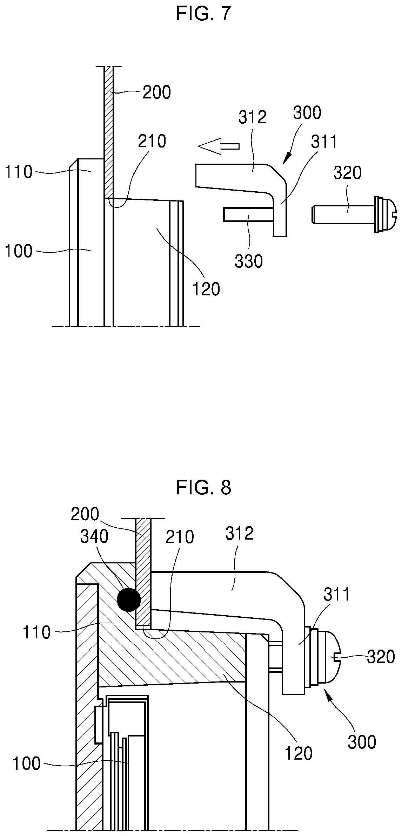

FIG. 7 is a view showing the electronic device fixed to the enclosure by using the bracket according to the exemplary embodiment of the present invention.

FIG. 8 is a view showing the elastic member interposed between the front cover and the enclosure according to the exemplary embodiment of the present invention.

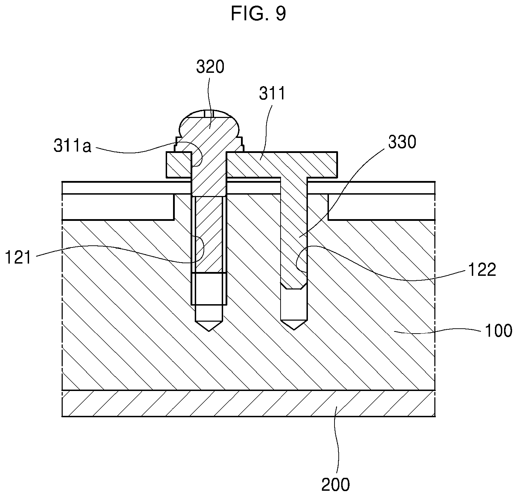

FIG. 9 is a cross-sectional view showing the bracket when it is installed.

The electronic device 100 may be located in the opening 210 formed in the enclosure 200 as shown in FIGS. 3 and 4.

The front cover 110 is in contact with the front face of the enclosure 200, and the rear part of the electronic device 100 protrudes along the rear face of the enclosure 200.

The plurality of brackets 300 according to the exemplary embodiment of the present invention is disposed.

A process of installing the brackets 300 will be described with reference to FIGS. 6 to 9.

The first portion 311 of each of the brackets 300 is fastened by fastening the coupling member 320 inserted into the through hole 311a into the fastening hole 121 formed in the periphery of the rear part of the electronic device 100.

In addition, the second portion 312 is located on the outer surface of the periphery 120 of the rear part of the electronic device 100.

At this time, an end of the second portion 312 faces the rear face of the enclosure 200.

Subsequently, the coupling member 320 is rotated to be gradually fastened into the fastening hole 121.

Accordingly, the second portion 312 is moved close to the rear face of the enclosure 200 at the outer side surface of the periphery of the rear part 120 of the electronic device 200, thereby pressing the rear face of the enclosure 200.

In this manner, the front cover 110 and the end of the second portion 312 can be pressed towards each other with the enclosure 200 therebetween, so that the electronic device 100 can be stably fixed in the opening 210.

In addition, a guide rod 330 protruding from the first portion 311 is formed. The guide rod 330 is to be inserted into a guide hole 122 formed in the periphery of the rear part 120 of the electronic device 100 so as to be movable.

Accordingly, the movement of the second portion 312 in the process of fastening the coupling member 320 as described above is guided, and thus it is possible to prevent the second portion 312 from deviating.

In addition, as shown in FIG. 8, an elastic member 340 is interposed between the front cover 110 and the enclosure 200. Accordingly, when the front cover 110 and the end of the second portion 312 are pressed towards each other, with the enclosure 200 therebetween, an elastic force may be applied to increase the efficiency of the degree of contact and to absorb external impact.

In addition, since the elastic member 340 is interposed, it is possible to prevent foreign matter from being introduced into the opening 210 where the electronic device 100 is fixed.

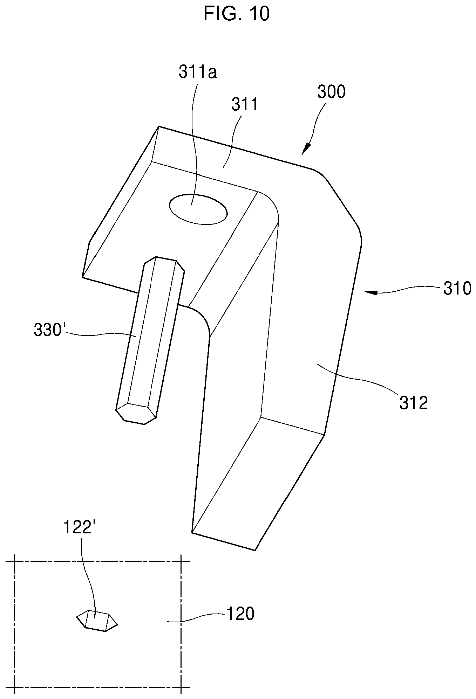

FIG. 10 is a view showing another example of the guide member.

Referring to FIG. 10, the longitudinal section of the guide rod 330' according to this example may have a polygonal shape.

That is, the guide rod 330' according to this example may have a polygonal shape and may be formed as a rod having a certain length.

In addition, a guide hole 122' formed in the periphery 120 of the rear part of the electronic device 100 may also be formed as a polygonal groove.

Therefore, the guide rod 330' formed in a polygonal shape may move back and forth as being inserted into the polygonal guide hole 122'.

As the polygonal guide rod 330' and guide hole 122' are coupled to each other, it is possible to prevent rotation of the guide rod 330' while it is moving in the guide hole 122'.

Therefore, the guide rod 330' is not rotated in the process of bringing the second portion 312 into contact with the rear face of the enclosure 200, and thus it is possible to effectively prevent a problem that the second portion 312 deviates along the rotation direction.

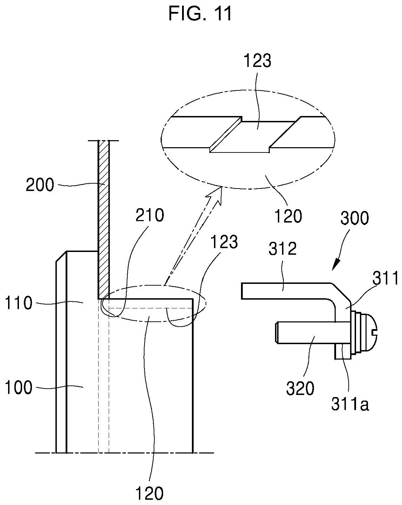

FIG. 11 is a view showing an example of a guide groove formed in an outer side surface of the periphery of the rear part of the electronic device.

Referring to FIG. 11, according to this exemplary embodiment, a guide groove 123 may be formed on the outer surface of the periphery of the rear part 120 of the electronic device 100.

Preferably, the width of the guide groove 123 may be substantially equal to the width of the second portion 312.

Preferably, the guide groove 123 may be formed along the moving direction of the second portion 312.

Accordingly, the second portion 312 is moved along the guide groove 123 in the process of bringing the second portion 312 into contact with the enclosure 200, so that it is possible to prevent the deviation of the moving path.

In addition, when an external impact is applied to the enclosure 200, it is possible to prevent that the end portion of the second portion 312 in contact with the rear face of the enclosure 200 deviates.

According to the above-described configuration and operation, the bracket according to the exemplary embodiments of the present invention can form a stable fixing force, so that the electronic device can be fixed to the enclosure.

While the present invention has been described in connection with the exemplary embodiments of the brackets for fixing an electronic device, it is to be appreciated that various modifications and variations can be made without departing from the scope of the present invention.

Accordingly, the scope of the present invention is not construed as being limited to the above-described embodiments but is defined by the appended.

Therefore, it should be understood that the above-mentioned embodiments are not restrictive but are illustrative in all aspects. It should be understood that the drawings and the detailed description are not intended to limit the present invention to the particular forms disclosed herein, but on the contrary, the intention is to cover all modifications and alternatives falling within the scope of the present invention as defined by the appended claims.

## Claims

1. An electronic device (100) having a bracket (300), wherein the electronic device (100) is to be accommodated in an opening (210) formed in an enclosure (200) and has a front cover (110) to be in tight contact with a front face of the enclosure (200) in the vicinity of the opening, the bracket (300) comprising:
a bracket body (310) that has a first end supporting a rear part of the electronic device and a second end in contact with a periphery of the rear part of the electronic device; and
a coupling member (320) disposed in the bracket body (310) to press the front cover and the second end of the bracket body towards each other from the front and rear faces of the enclosure, to fix the electronic device,
wherein the bracket body (310) comprises:
a first portion (311) having a fastening hole (311a) through which the coupling member passes; and a second portion (312) bent from an end of the first portion so as to partially surround the periphery (120) of the rear part of the electronic device,
wherein the coupling member (320) is coupled with the periphery of the rear part of the electronic device by being screwed, and an end of the second portion forms a supporting region to be in tight contact with the rear face of the enclosure near the opening, **characterised in that**
the bracket body (310) is formed in an L shape, and
a connection portion between the first portion (311) and the second portion (312) is formed to be tapered.

2. The electronic device of claim 1, wherein a guide hole (122) is formed in the periphery of the rear part of the electronic device, and
wherein a guide rod (330) protrudes from the first portion such that the guide rod (330) is to be inserted into the guide hole to guide movement.

3. The electronic device of claim 2, wherein the guide hole (122) is formed in a shape conforming to the guide rod (330),
wherein a longitudinal section of the guide rod (330) is formed in a polygonal shape.

4. The electronic device of claim 1, wherein a guide groove (123) for guiding movement of the second portion is further formed in the periphery of the rear part of the electronic device.

5. The electronic device of claim 1, wherein an elastic member (340) is to be interposed between the front cover and the enclosure.

6. A mechanism for fixing an electronic device (100) to an enclosure (200) by using the bracket (300) according to claim 1.

## Patentansprüche

1. Elektronische Vorrichtung (100) mit einer Halterung (300), wobei die elektronische Vorrichtung (100) in einer Öffnung (210) unterzubringen ist, die in einer Umhausung (200) ausgebildet ist, und eine vordere Abdeckung (110) aufweist, die in engem Kontakt mit einer vorderen Fläche der Umhausung (200) in der Nähe der Öffnung sein soll, die Halterung (300) umfassend:
einen Halterungskörper (310), der ein erstes Ende, das einen hinteren Teil der elektronischen Vorrichtung trägt, und ein zweites Ende, das in Kontakt mit einem äußeren Rand des hinteren Teils der elektronischen Vorrichtung ist, aufweist; und
ein Kopplungselement (320), das in dem
Halterungskörper (310) angeordnet ist, zum Drücken der vorderen Abdeckung und des zweiten Endes des Halterungskörpers von der vorderen und der hinteren Fläche der Umhausung aus zueinander, um die elektronische Vorrichtung zu befestigen,
wobei der Halterungskörper (310) umfasst:
einen ersten Abschnitt (311), der ein
Befestigungsloch (311a) aufweist, durch das das Kopplungselement verläuft; und einen zweiten Abschnitt (312), der von einem Ende des ersten Abschnitts aus so gebogen ist, dass er den äußeren Rand (120) des hinteren Teils der elektronischen Vorrichtung teilweise umgibt,
wobei das Kopplungselement (320) mit dem äußeren Rand des hinteren Teils der elektronischen Vorrichtung gekoppelt ist, indem es verschraubt wird, und ein Ende des zweiten Abschnitts einen Stützbereich bildet, um in engem Kontakt mit der hinteren Fläche der Umhausung nahe der Öffnung zu sein, **dadurch gekennzeichnet, dass** der Halterungskörper (310) in einer L-Form ausgebildet ist, und ein Verbindungsabschnitt zwischen dem ersten Abschnitt (311) und dem zweiten Abschnitt (312) so ausgebildet ist, dass er sich verjüngt.

2. Elektronische Vorrichtung nach Anspruch 1, wobei ein Führungsloch (122) in dem äußeren Rand des hinteren Teils der elektronischen Vorrichtung ausgebildet ist, und
wobei eine Führungsstange (330) von dem ersten Abschnitt so vorsteht, dass die Führungsstange (330) in das Führungsloch einzuführen ist, um die Bewegung zu führen.

3. Elektronische Vorrichtung nach Anspruch 2, wobei das Führungsloch (122) in einer Form ausgebildet ist, die mit der Führungsstange (330) übereinstimmt,
wobei ein Längsschnitt der Führungsstange (330) in einer polygonalen Form ausgebildet ist.

4. Elektronische Vorrichtung nach Anspruch 1, wobei eine Führungsnut (123) zum Führen der Bewegung des zweiten Abschnitts ferner in dem äußeren Rand des hinteren Teils der elektronischen Vorrichtung ausgebildet ist.

5. Elektronische Vorrichtung nach Anspruch 1, wobei ein elastisches Element (340) zwischen der vorderen Abdeckung und der Umhausung anzuordnen ist.

6. Mechanismus zum Befestigen einer elektronischen Vorrichtung (100) an einer Umhausung (200) unter Verwendung der Halterung (300) nach Anspruch 1.

## Revendications

1. Dispositif électronique (100) ayant une ferrure (300), dans lequel le dispositif électronique (100) doit être logé dans une ouverture (210) formée dans une enceinte (200) et a un capot avant (110) pour être en contact étroit avec une face avant de l'enceinte (200) à proximité de l'ouverture, la ferrure (300) comprenant :
un corps de ferrure (310) qui a une première extrémité supportant une partie arrière du dispositif électronique et une deuxième extrémité en contact avec une périphérie de la partie arrière du dispositif électronique ; et
un élément de couplage (320) disposé dans le corps de ferrure (310) pour appuyer le capot avant et la deuxième extrémité du corps de ferrure l'un vers l'autre à partir des faces avant et arrière de l'enceinte, afin de fixer le dispositif électronique,
dans lequel le corps de ferrure (310) comprend :
une première portion (311) ayant un trou d'attache (311a) à travers lequel passe l'élément de couplage ; et une deuxième portion (312) courbée à partir d'une extrémité de la première portion de manière à entourer partiellement la périphérie (120) de la partie arrière du dispositif électronique,
dans lequel l'élément de couplage (320) est couplé à la périphérie de la partie arrière du dispositif électronique en étant vissé, et une extrémité de la deuxième portion forme une région de support pour être en contact étroit avec la face arrière de l'enceinte près de l'ouverture, **caractérisé en ce que** le corps de ferrure (310) est formé en forme de L, et une portion de raccordement entre la première portion (311) et la deuxième portion (312) est formée pour être effilée.

2. Dispositif électronique selon la revendication 1, dans lequel un trou de guidage (122) est formé dans la périphérie de la partie arrière du dispositif électronique, et
dans lequel une tige de guidage (330) fait saillie à partir de la première portion de sorte que la tige de guidage (330) doit être insérée dans le trou de guidage pour guider un déplacement.

3. Dispositif électronique selon la revendication 2, dans lequel le trou de guidage (122) est formé en une forme se conformant à la tige de guidage (330),
dans lequel une section longitudinale de la tige de guidage (330) est formée en une forme polygonale.

4. Dispositif électronique selon la revendication 1, dans lequel une rainure de guidage (123) destinée à guider un déplacement de la deuxième portion est en outre formée dans la périphérie de la partie arrière du dispositif électronique.

5. Dispositif électronique selon la revendication 1, dans lequel un élément élastique (340) doit être interposé entre le capot avant et l'enceinte.

6. Mécanisme de fixation d'un dispositif électronique (100) à une enceinte (200) par l'utilisation de la ferrure (300) selon la revendication 1.
